# EUROPEAN PATENT APPLICATION

(11) **EP 4 191 640 A1**
(43) Date of publication of application: **07.06.2023**
(21) Application number: 22210082.8
(22) Date of filing: 29.11.2022
(51) Int. Cl.: H01L 21/02, H01L 21/67, B23K 26/00

(54) **WAFER PRODUCTION METHOD AND WAFER PRODUCTION MACHINE**

(30) Priority: 06.12.2021 JP 2021197931
(71) Applicant: Disco Corporation, Tokyo 143-8580 (JP)
(72) Inventor: NAGAMI, Masaru, Tokyo, 143-8580 (JP)
(74) Representative: Hoffmann Eitle

(57) **Abstract**

A wafer production method includes a separating layer forming step of forming, in the ingot, a separating layer that includes modified portions and cracks, by relatively moving the ingot and a focal point of a laser beam of a wavelength having transmissivity for the ingot, with the focal point positioned at a depth corresponding to a thickness of the wafer, a wafer separating step of separating the wafer from the ingot by using the separating layer as a separation starting interface, a tape bonding step of bonding an adhesive tape to at least one of a separated surface of the wafer and a resulting fresh end surface of the ingot, a tape separating step of removing separation debris stuck on the at least one surface, by separating the adhesive tape from the at least one surface, and a grinding step of grinding the at least one surface from which the separation debris has been removed. A wafer production machine is also disclosed.

## Description

### BACKGROUND OF THE INVENTION

### Field of the Invention

The present invention relates to a wafer production method and a wafer production machine.

### Description of the Related Art

As a production method of a wafer such as a semiconductor wafer on which devices are to be formed, a method is known in which an ingot generally of a cylindrical shape is sliced thin by a wire saw, followed by polishing of the resulting wafer on front and back surfaces thereof. The slicing by the wire saw, however, has a problem in that it is uneconomical because a large majority of the ingot is disposed of.

To solve this problem, a technique has been proposed in which a laser beam of a wavelength which has transmissivity for an ingot is applied to the ingot with a focal point thereof positioned inside the ingot to form a separating layer in the ingot, and a wafer is then separated from the ingot by using the separating layer as a separation starting interface (see JP 2016-111143A and JP 2019-102513A). The wafer separated from the ingot as described above is ground on a separated surface thereof to form a wafer having a predetermined thickness.

### SUMMARY OF THE INVENTION

However, needle-like separation debris remains as a contaminant on a wafer and an ingot after separation. If the wafer is ground as it is, the needle-like contaminant sticks on grinding stones, thereby possibly inducing a deterioration of processing quality, chipping of the grinding stones, and the like.

The present invention therefore has as objects thereof the provision of a wafer production method and a wafer production machine which can remove separation debris occurred upon separation of a wafer from an ingot and can hence reduce a processing failure.

In accordance with an aspect of the present invention, there is provided a wafer production method of producing a wafer from an ingot having a first surface and a second surface on a side opposite to the first surface. The wafer production method includes a separating layer forming step of forming, in the ingot, a separating layer that includes modified portions and cracks propagating from the modified portions, by relatively moving the ingot and a focal point of a laser beam of a wavelength having transmissivity for the ingot, with the focal point positioned at a depth corresponding to a thickness of the wafer to be produced from a side of the first surface, a wafer separating step of separating the wafer from the ingot by using the separating layer as a separation starting interface, a tape bonding step of, after the wafer separating step is performed, bonding an adhesive tape to at least one of a separated surface of the wafer and a resulting fresh end surface of the ingot, a tape separating step of removing separation debris stuck on the at least one surface, by separating the adhesive tape that has been bonded to the at least one surface in the tape bonding step from the at least one surface, and a grinding step of, after the tape separating step is performed, grinding the at least one surface from which the separation debris has been removed.

In accordance with another aspect of the present invention, there is provided a wafer production machine for producing a wafer from an ingot. The wafer production machine includes a laser beam irradiation unit configured to form a separating layer in the ingot by applying a laser beam of a wavelength having transmissivity for the ingot to the ingot with a focal point of the laser beam positioned at a depth corresponding to a thickness of the wafer to be produced from an upper surface of the ingot, a separating unit configured to separate the wafer from the ingot by using, as a separation starting interface, the separating layer formed by the laser beam irradiation unit, a separation debris removing unit configured to remove separation debris that are present on at least one of a separated surface of the wafer that has been separated from the ingot by the separating unit and a resulting fresh end surface of the ingot, from the at least one surface, by bonding an adhesive tape to the at least one surface and separating the adhesive tape from the at least one surface with the separation debris stuck on the adhesive tape, and a grinding unit including grinding stones that grind and planarize the at least one surface.

The present invention can remove separation debris occurred upon separation of a wafer from an ingot, and can hence reduce a processing failure.

The above and other objects, features and advantages of the present invention and the manner of realizing them will become more apparent, and the invention itself will best be understood from a study of the following description and appended claims with reference to the attached drawings showing some preferred embodiments of the invention.

### BRIEF DESCRIPTION OF THE DRAWINGS

FIG. 1 is a perspective view of an ingot to be processed by a wafer production method according to an embodiment of a first aspect of the present invention;
FIG. 2 is a side view of the ingot depicted in FIG. 1;
FIG. 3 is a flow chart diagram illustrating a flow of the wafer production method according to the embodiment of the first aspect of the present invention;
FIG. 4 is a schematic perspective view of a laser beam irradiation unit of a wafer production machine according to an embodiment of a second aspect of the present invention, and depicts a state in a separating layer forming step illustrated in FIG. 3;
FIG. 5 is a top view of the ingot in FIG. 4;
FIG. 6 is a schematic side view of a separating unit of the wafer production machine, and depicts a state in a wafer separating step illustrated in FIG. 3;
FIG. 7 is a schematic side view of the separating unit of the wafer production machine, and depicts a state after the state of FIG. 6 in the wafer separating step illustrated in FIG. 3;
FIG. 8 is a schematic side view depicting a configuration example of a separation debris removing unit of the wafer separation machine which is performing a tape bonding step and a tape separating step illustrated in FIG. 3;
FIG. 9 is a schematic top view of a resulting fresh end surface of the ingot and a bonding roller of the separation debris removing unit, and depicts a state in the tape bonding step illustrated in FIG. 3;
FIG. 10 is a schematic side view of the separation debris removing unit of the wafer production machine, and depicts a state in the tape separating step illustrated in FIG. 3; and
FIG. 11 is a schematic perspective view of a grinding unit of the wafer production machine, and depicts a state in a grinding step illustrated in FIG. 3.

### DETAILED DESCRIPTION OF THE PREFERRED EMBODIMENTS

With reference to the attached drawings, a description will hereinafter be made in detail regarding an embodiment of a first aspect and an embodiment of a second aspect of the present invention. However, the present invention shall not be limited by details that will be described in the subsequent embodiments. The elements of configurations that will hereinafter be described include those readily conceivable to persons skilled in the art and substantially the same ones. Further, the configurations that will hereinafter be described can be combined appropriately. Moreover, various omissions, replacements, and modifications of configurations can be made without departing from the spirit of the present invention.

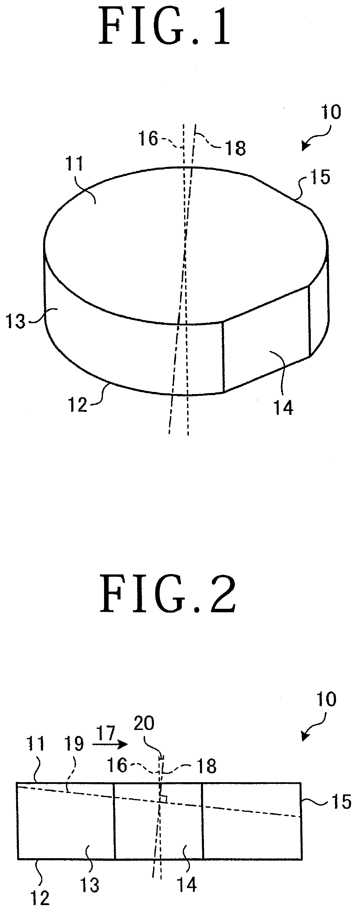

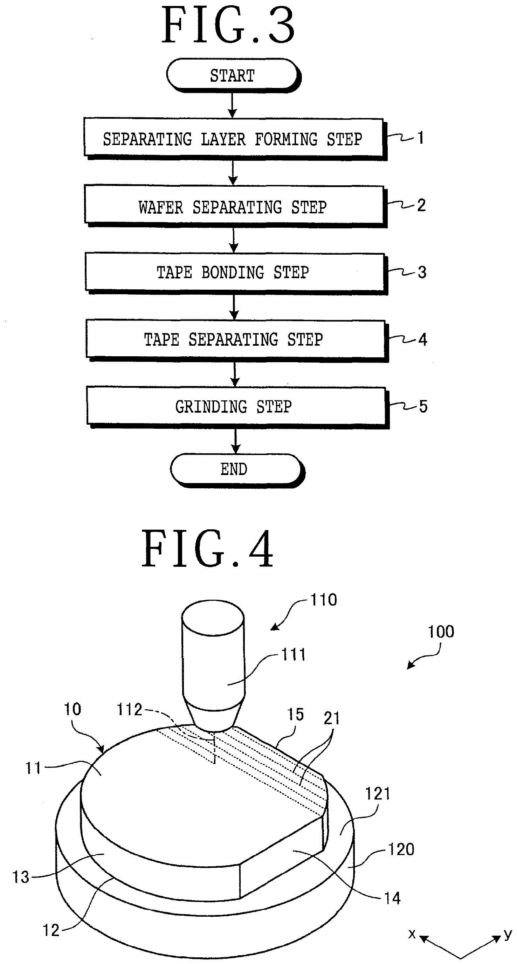

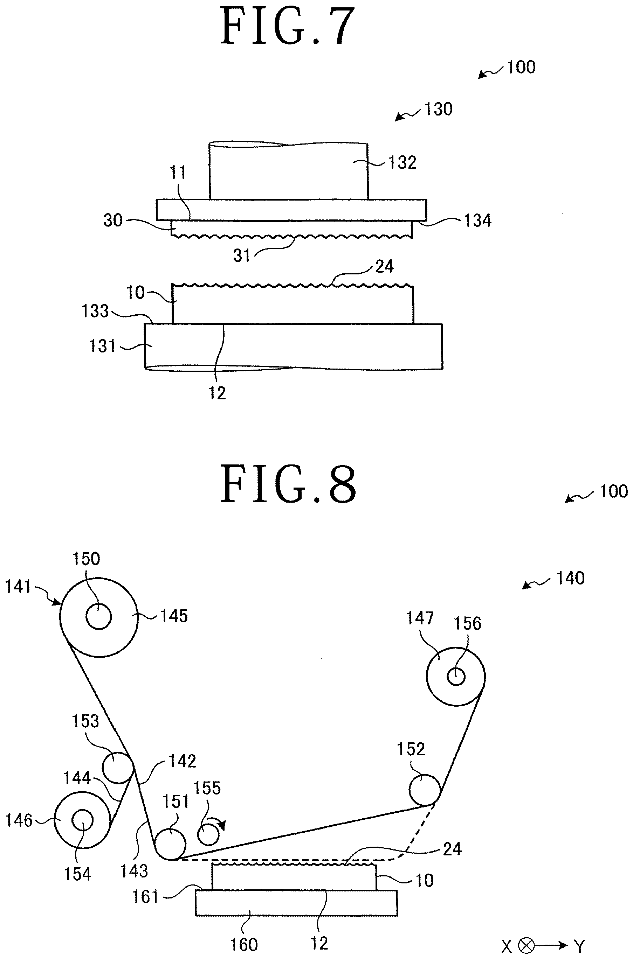

A wafer production method according to the embodiment of the first aspect of the present invention and a wafer production machine 100 according to the embodiment of the second aspect of the present invention will be described based on FIGS. 1 to 11. Described specifically, by using the wafer production machine 100 including processing units depicted in FIGS. 4, 6, 7, 8, 10, and 11, the wafer production method of the embodiment separates a wafer 30 depicted in FIG. 7 from an ingot 10 depicted in FIGS. 1 and 2, removes separation debris from a separated surface 31 of the wafer 30 or a resulting fresh end surface 24 (hereinafter simply called the "fresh end surface 24") of the ingot 10, and then grinds the separated surface 31 or the fresh end surface 24.

### (SiC Single-crystal Ingot)

A description will first be made regarding the structure of the ingot 10 to be processed by the wafer production method according to the present embodiment. FIG. 1 is a perspective view of the ingot 10 to be processed by the wafer production method according to the present embodiment. FIG. 2 is a side view of the ingot 10 depicted in FIG. 1.

The ingot 10 depicted in FIGS. 1 and 2 is made from silicon carbide (SiC) and is formed in a cylindrical shape as a whole. In the present embodiment, the ingot 10 is a hexagonal single-crystal SiC ingot. The ingot 10 has a first surface 11, a second surface 12, a peripheral surface 13, a first orientation flat 14, and a second orientation flat 15.

The first surface 11 is circular and is one of end surfaces of the ingot 10 formed in the circular shape. The second surface 12 is circular and is the end surface on a side opposite to the first surface 11 of the ingot 10 formed in the cylindrical shape. The second surface 12 corresponds to a bottom surface of the ingot 10. The peripheral surface 13 extends to an outer edge of the first surface 11 and an outer edge of the second surface 12.

The first orientation flat 14 is a flat surface formed at a portion of the peripheral surface 13 to indicate a crystal orientation of the ingot 10. The second orientation flat 15 is a flat surface formed at another portion of the peripheral surface 13 to indicate another crystal orientation of the ingot 10. The second orientation flat 15 is orthogonal to the first orientation flat 14. It is to be noted that the first orientation flat 14 is longer than the second orientation flat 15 as seen in a peripheral direction of the ingot 10.

The ingot 10 also has a c-axis 18 and a c-plane 19. The c-axis 18 is inclined at an off-angle 20, relative to a normal 16 to the first surface 11, in an incline direction 17 toward the second orientation flat 15. The c-plane 19 is orthogonal to the c-axis 18. The incline direction 17 of the c-axis 18 from the normal 16 is orthogonal to the direction of an extension of the second orientation flat 15 and is parallel to the first orientation flat 14. The c-plane 19 is inclined at the off-angle 20 relative to the first surface 11 of the ingot 10.

On the molecular level of the ingot 10, an innumerable number of c-planes 19 are set in the ingot 10. In the present embodiment, the off-angle α is set to 1°, 4°, or 6°. In the present invention, however, the ingot 10 may be produced by setting the off-angle 20 as desired, for example, in a range of 1° to 6°. After the first surface 11 has been subjected to grinding processing by a grinding machine, the ingot 10 is then subjected to polishing processing by a polishing machine, whereby the first surface 11 is formed into a mirror surface.

### (Wafer Production Method and Wafer Production Machine 100)

A description will next be made regarding the wafer production method according to the present embodiment. FIG. 3 is a flow chart diagram illustrating a flow of the wafer production method according to the present embodiment. The wafer production method includes a separating layer forming step 1, a wafer separating step 2, a tape bonding step 3, a tape separating step 4, and a grinding step 5.

The separating layer forming step 1, wafer separating step 2, tape bonding step 3, tape separating step 4, and grinding step 5 are performed by using the wafer production machine 100 that includes the processing units depicted in FIGS. 4, 6, 7, 8, 10, and 11. The wafer production machine 100 includes a laser beam irradiation unit 110 that performs the separating layer forming step 1, a separating unit 130 that performs the wafer separating step 2, a separation debris removing unit 140 that performs the tape bonding step 3 and tape separating step 4, a grinding unit 170 that performs the grinding step 5, and holding tables 120, 160, and 180.

### <Separating Layer Forming Step 1>

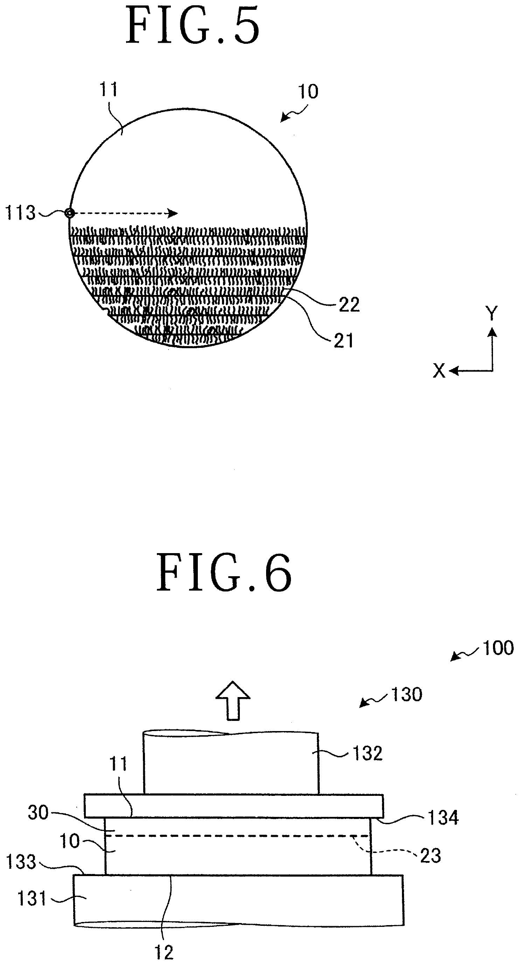

FIG. 4 is a schematic perspective view of the laser beam irradiation unit 110, and depicts a state in the separating layer forming step 1 illustrated in FIG. 3. FIG. 5 is a top view of the ingot 10 in FIG. 4. In the separating layer forming step 1, a separating layer 23 (see FIG. 6) that includes modified portions 21 and cracks 22 is formed by a laser beam 112 at a depth corresponding to a thickness of the wafer 30 to be produced, from a side of the first surface 11 of the ingot 10.

The separating layer forming step 1 is performed by the laser beam irradiation unit 110 of the wafer production machine 100. The laser beam irradiation unit 110 has, for example, a laser oscillator that emits the laser beam 112, a condenser 111 that condenses the laser beam 112 toward the ingot 10 held on the holding table 120, and a variety of optical components that guide the laser beam 112 from the laser oscillator to the condenser 111.

The holding table 120 holds the ingot 10 on a holding surface 121 thereof. The holding surface 121 is formed from porous ceramics or the like and is in a disk shape. In the present embodiment, the holding surface 121 is a flat surface parallel to a horizontal direction. The holding surface 121 is connected, for example, to a vacuum suction source via a vacuum suction channel. The holding table 120 holds the second surface 12 of the ingot 10 by suction on the holding surface 121.

The laser beam irradiation unit 110 applies the laser beam 112 of a wavelength which has transmissivity for the ingot 10, to the ingot 10 held on the holding surface 121 of the holding table 120. The laser beam irradiation unit 110 and the holding table 120 can be moved relative to each other by a moving unit (not depicted). It is to be noted that, in the following description, an X-axis direction is one direction in a horizontal plane, and a Y-axis direction is a direction orthogonal to the X-axis direction in the horizontal plane. It is also to be noted that, in the embodiments, the X-axis direction is a processing feed direction, and the Y-axis direction is an indexing feed direction.

In the separating layer forming step 1, the second surface 12 of the ingot 10 is first held by suction on the holding surface 121 of the holding table 120. Here, the position of the ingot 10 is adjusted such that the second orientation flat 15 of the ingot 10 extends parallel to the processing feed direction (X-axis direction). A focal point 113 of the laser beam 112 is next positioned inside the ingot 10 at the depth corresponding to the thickness of the wafer 30 (see FIG. 6, etc.) to be produced. The laser beam 112 is a pulsed laser beam of the wavelength having transmissivity for the ingot 10.

In the separating layer forming step 1, with the focal point 113 positioned inside the ingot 10 at the depth corresponding to the thickness of the wafer 30 (see FIG. 6, etc.) to be produced, the condenser 111 of the laser beam irradiation unit 110 and the holding table 120 are relatively moved next. Described specifically, the laser beam 112 is applied toward the ingot 10 while the focal point 113 and the ingot 10 are relatively moved in alternate directions (alternately in the X and Y directions) parallel to the first surface 11.

In the separating layer forming step 1, SiC dissociates into silicon (Si) and carbon (C) by the application of the pulsed laser beam 112. The pulsed laser beam 112 applied next is then absorbed in the C formed previously, and SiC dissociates into Si and C in a chain manner. As a consequence, the modified portions 21 are formed along the processing feed direction inside the ingot 10, and at the same time, the cracks 22 are formed extending from the modified portions 21 along the c-plane 19 (see FIG. 2). The cracks 22 therefore propagate in the indexing feed direction (Y-axis direction) in the present embodiment. In the separating layer forming step 1, the separating layer 23 including the modified portions 21 and the cracks 22 extending along the c-plane 19 from the modified portions 21 is formed as described above.

### <Wafer Separating Step 2>

FIG. 6 is a schematic side view of the separating unit 130, and depicts a state in the wafer separating step 2 illustrated in FIG. 3. FIG. 7 is a schematic side view of the separating unit 130, and depicts a state after the state of FIG. 6 in the wafer separating step 2 illustrated in FIG. 3. In the wafer separating step 2, the wafer 30 is separated from the ingot 10 by using, as a separation starting interface, the separating layer 23 formed in the separating layer forming step 1.

The wafer separating step 2 is performed by the separating unit 130. The separating unit 130 has, for example, an ingot holding unit 131 that holds the ingot 10, a wafer holding unit 132 that holds the wafer 30 to be separated, and a moving unit (not depicted) that relatively moves the ingot holding unit 131 and the wafer holding unit 132.

The ingot holding unit 131 holds the ingot 10 on a holding surface 133 thereof. The holding surface 133 is formed from porous ceramics or the like and is in a disk shape. In the present embodiment, the holding surface 133 is a flat surface parallel to the horizontal direction. The holding surface 133 is connected, for example, to the vacuum suction source via a vacuum suction channel. The ingot holding unit 131 holds the second surface 12 of the ingot 10 by suction on the holding surface 133.

The wafer holding unit 132 holds the wafer 30 to be separated, by suction on a holding surface 134 thereof. The holding surface 134 is formed from porous ceramics or the like and is in a disk shape. In the present embodiment, the holding surface 134 is a flat surface parallel to the horizontal direction and is facing the holding surface 133 of the ingot holding unit 131. The holding surface 134 is connected, for example, to the vacuum suction source via a vacuum suction channel. The wafer holding unit 132 holds the ingot 10 by suction on the holding surface 134 with the first surface 11 brought into contact with the holding surface 134. The wafer holding unit 132 is movable close to or away from the ingot holding unit 131 by a moving unit (not depicted).

It is to be noted that the holding table 120 may be used as the ingot holding unit 131. Described specifically, the ingot 10 with the separating layer 23 formed therein by the laser beam irradiation unit 110 may be transferred to a position facing the wafer holding unit 132 while being still held on the holding table 120.

In the wafer separating step 2, the second surface 12 of the ingot 10 is first held by suction on the holding surface 133 of the ingot holding unit 131 as depicted in FIG. 6. The wafer holding unit 132 is next brought close to a side of the ingot holding unit 131, and the first surface 11 of the ingot 10 is held by suction on the holding surface 134. In this state, the wafer holding unit 132 is next moved apart from the ingot holding unit 131 as depicted in FIG. 7. As a consequence, the ingot 10 is pulled in opposite vertical directions and is separated by using the separating layer 23 as the separation starting interface. Accordingly, a separated portion of the ingot 10 which includes the first surface 11 is obtained as the wafer 30 as separated.

### <Tape Bonding Step 3 and Tape Separating Step 4>

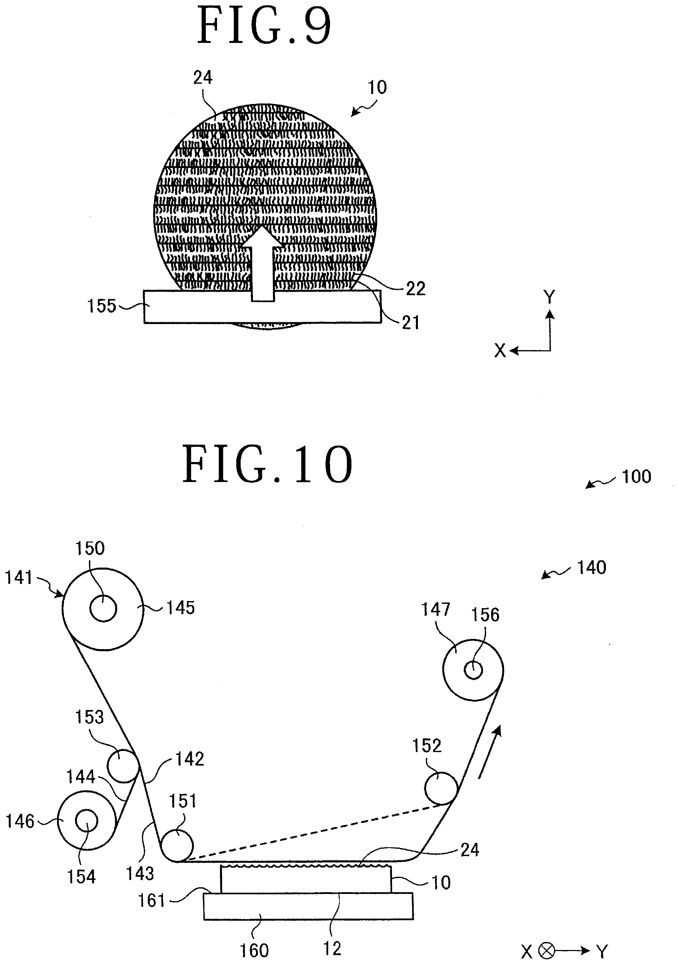

FIG. 8 is a schematic side view depicting a configuration example of the separation debris removing unit 140 of the wafer production machine 100 which is performing the tape bonding step 3 and tape separating step 4 illustrated in FIG. 3. FIG. 9 is a schematic top view of the fresh end surface 24 of the ingot 10 and a bonding roller 155 of the separation debris removing unit 140, and depicts a state in the tape bonding step 3 illustrated in FIG. 3. FIG. 10 is a schematic side view of the separation debris removing unit 140, and depicts a state in the tape separating step 4 illustrated in FIG. 3.

The tape bonding step 3 is performed after the wafer separating step 2 is performed. In the tape bonding step 3, an adhesive tape 141 is bonded to at least one of the separated surface 31 (see FIG. 7) of the wafer 30 held on the holding table 160 and the fresh end surface 24 of the ingot 10 held on the holding table 160 (in the example depicted in FIGS. 8 to 10, the adhesive tape 141 is bonded to the fresh end surface 24). Then, in the tape separating step 4, the adhesive tape 141 bonded in the tape bonding step 3 is separated, so that the separation debris stuck on the separated surface 31 or the fresh end surface 24 is removed from the separated surface 31 or the fresh end surface 24.

The tape bonding step 3 and the below-mentioned tape separating step 4 are performed by the separation debris removing unit 140 of the wafer production machine 100. The separation debris removing unit 140 bonds the adhesive tape 141 to the separated surface 31 of the wafer 30 held on the holding table 160 or the fresh end surface 24 of the ingot 10 held on the holding table 160, and then separates the bonded adhesive tape 141 from the separated surface 31 or the fresh end surface 24 to remove separation debris from the separated surface 31 or the fresh end surface 24. The separation debris removing unit 140 has a support roller 150, transfer rollers 151 and 152, a peel roller 153, a release paper winding roller 154, the bonding roller 155, and a tape winding roller 156.

The adhesive tape 141 includes a base material layer 142 and an adhesive layer 143 stacked on the base material layer 142. The base material layer 142 has flexibility as a whole and is formed from a non-adhesive synthetic resin. The adhesive layer 143 is formed from a synthetic resin having such adhesiveness that the adhesive tape 141 can be bonded to and then separated from the separated surface 31 or the fresh end surface 24. In the present embodiment, the adhesive tape 141 is formed as an elongated, tape-shaped member and is wound in a roll shape with a release paper tape 144 bonded to the adhesive layer 143, and a tape roll 145 is thus formed.

The support roller 150 is formed in a cylindrical shape and is disposed rotatably about an axial center extending in the horizontal direction. In the present embodiment, the axial center of the support roller 150 is parallel to the X-axis direction. With the support roller 150 inserted in a core of the tape roll 145, the support roller 150 supports the tape roll 145 rotatably about the horizontal axial center thereof. The support roller 150 fixedly holds, on an outer peripheral surface thereof, an inner peripheral surface of the core of the tape roll 145 and allows the tape roll 145 to rotate about the axial center thereof, whereby the adhesive tape 141 is paid out successively from a leading end thereof to above a holding surface 161 of the holding table 160.

Each of the transfer rollers 151 and 152 is formed in a cylindrical shape and is disposed rotatably about its axial center extending parallel to the axial center of the support roller 150. The transfer roller 151 is arranged above one end portion of the holding table 160 in the X-axis direction and between the holding table 160 and the support roller 150. The transfer roller 152 is arranged above the other end portion of the holding table 160 in the X-axis direction. The transfer rollers 151 and 152 transfer the adhesive tape 141 from the support roller 150 to the tape winding roller 156, and also apply a tension to the adhesive tape 141 in order to suppress occurrence of a slack in the adhesive tape 141. The transfer rollers 151 and 152 press, at outer peripheral surfaces thereof, the base material layer 142 of the adhesive tape 141 toward the holding table 160, and the tension is thus applied to the adhesive tape 141.

The peel roller 153 is formed in a cylindrical shape and is disposed rotatably about its axial center extending parallel to the axial centers of the support roller 150 and the transfer rollers 151 and 152. The peel roller 153 is arranged between the support roller 150 and the transfer roller 151, and peels off the release paper tape 144, which is bonded to the adhesive layer 143 of the adhesive tape 141, from the adhesive tape 141. The peel roller 153 presses, at an outer peripheral surface thereof, the release paper tape 144 bonded to the adhesive tape 141 paid out from the support roller 150, so that the release paper tape 144 is peeled off from the adhesive tape 141.

The release paper winding roller 154 is formed in a cylindrical shape and is disposed rotatably by a driving unit (not depicted) such as a motor about its axial center extending parallel to the axial centers of the support roller 150, the transfer rollers 151 and 152, and the peel roller 153. The release paper winding roller 154 is arranged below the support roller 150. When rotated, the release paper winding roller 154 takes up, on an outer peripheral surface thereof, the release paper tape 144 peeled off by the peel roller 153 from the adhesive tape 141 paid out from the support roller 150. The release paper tape 144 taken up on the release paper winding roller 154 is wound in a roll shape, and a tape roll 146 is thus formed.

The bonding roller 155 is formed in a cylindrical shape and is supported rotatably about its axial center extending parallel to the axial centers of the support roller 150, the transfer rollers 151 and 152, the peel roller 153, and the release paper winding roller 154. The bonding roller 155 is arranged above the holding surface 161 of the holding table 160. The bonding roller 155 is disposed in such a manner as to be movable up and down in a direction orthogonal to the holding surface 161 of the holding table 160 by a moving mechanism (not depicted) and also movable along the holding surface 161 in a direction orthogonal to an axial center of the bonding roller 155 by another moving mechanism (not depicted).

In a state of having been moved down by the moving mechanism, the bonding roller 155 rolls along the holding surface 161, whereby the bonding roller 155 presses and bonds the adhesive tape 141, which is supplied from the support roller 150 to above the holding surface 161 of the holding table 160, toward and to the separated surface 31 of the wafer 30 or the fresh end surface 24 of the ingot 10 held by suction on the holding surface 161 of the holding table 160. As a consequence, separation debris which is present on the separated surface 31 or the fresh end surface 24 adheres to the adhesive tape 141.

The tape winding roller 156 is formed in a cylindrical shape and is disposed rotatably by a driving unit (not depicted) such as a motor about its axial center extending parallel to the axial centers of the support roller 150, the transfer rollers 151 and 152, the peel roller 153, the release paper winding roller 154, and the bonding roller 155. The tape winding roller 156 is arranged above the other end portion of the holding table 160 in the X-axis direction and the transfer roller 152. When rotated, the tape winding roller 156 pays out the adhesive tape 141 from the tape roll 145 supported on the support roller 150, and takes up the adhesive tape 141 on an outer peripheral surface thereof. The adhesive tape 141 taken up on the tape winding roller 156 is wound in a roll shape, and a spent tape roll 147 is thus formed.

When rotated in the state that the adhesive tape 141 is stuck on the separated surface 31 of the wafer 30 or the fresh end surface 24 of the ingot 10 held by suction on the holding surface 161 of the holding table 160, the tape winding roller 156 separates the adhesive tape 141 from the separated surface 31 or the fresh end surface 24. As a consequence, separation debris which is present on the separated surface 31 or the fresh end surface 24 and which is stuck on the adhesive tape 141 is removed from the separated surface 31 or the fresh end surface 24.

The holding table 160 holds the ingot 10 (or the wafer 30) on the holding surface 161. The holding surface 161 is formed from porous ceramics or the like and is in a disk shape. In the present embodiment, the holding surface 161 is a flat surface parallel to the horizontal direction. The holding surface 161 is connected, for example, to the vacuum suction source via a vacuum suction channel. The holding table 160 holds the second surface 12 of the ingot 10 by suction on the holding surface 161, or holds the first surface 11 of the wafer 30, which has been separated from the ingot 10 in the wafer separating step 2, by suction on the holding surface 161.

It is to be noted that the ingot holding unit 131 may be used as the holding table 160. Described specifically, the ingot 10 from which the wafer 30 has been separated by the separating unit 130 may be transferred, while being still held on the ingot holding unit 131, to a position where the fresh end surface 24 faces the adhesive layer 143 of the adhesive tape 141. Further, the wafer holding unit 132 may be used as the holding table 160. Similarly, the wafer 30 which has been separated from the ingot 10 by the separating unit 130 may also be transferred, while being still held on the wafer holding unit 132, to a position where the separated surface 31 faces the adhesive layer 143 of the adhesive tape 141.

A description will be made regarding the case in which separation debris on the fresh end surface 24 of the ingot 10 is removed in the tape bonding step 3 and tape separating step 4. In the tape bonding step 3, first, the second surface 12 of the ingot 10 is held by suction on the holding surface 161 of the holding table 160 and is positioned below the adhesive tape 141 paid out from the support roller 150, as depicted in FIG. 8. Here, the ingot 10 is held on the holding surface 161 such that the second orientation flat 15 of the ingot 10 and the processing feed direction (X-axis direction) become parallel to each other.

As depicted in FIGS. 8 and 9, the bonding roller 155 is lowered and is then caused to roll along the holding surface 161 in the direction orthogonal to the axial center thereof, i.e., in the Y-axis direction, thereby bonding the adhesive tape 141 to the fresh end surface 24 of the ingot 10. As a consequence, separation debris which is present on the fresh end surface 24 sticks on the adhesive tape 141. It is to be noted that the bonding of the adhesive tape 141 by the bonding roller 155 may be performed on the fresh end surface 24 a plurality of times. In such a case, the bonding roller 155 may reciprocally be rolled to perform the bonding. Alternately, the bonding roller 155 may be once returned to an original position and may then be caused to roll again, and these returning and rolling may be repeated as many times as desired to perform the bonding. After the adhesive tape 141 has been bonded to the entire fresh end surface 24, the bonding roller 155 is raised to be moved apart from the adhesive tape 141 and is returned to a predetermined initial position. Owing to an adhesive force of the adhesive layer 143, the adhesive tape 141 remains bonded to the fresh end surface 24.

Next, in the tape separating step 4, the tape winding roller 156 is rotated to take up the adhesive tape 141 as depicted in FIG. 10. As a consequence, the adhesive tape 141 bonded to the fresh end surface 24 is pulled upward as indicated by an arrow and is separated from an end portion of the fresh end surface 24 on a side of the tape winding roller 156, so that, in a state of being stuck on the adhesive tape 141, separation debris is removed from the fresh end surface 24. The separation debris is then taken up and recovered together with the adhesive tape 141 on the tape winding roller 156.

It is to be noted that, in the tape bonding step 3, the direction in which the adhesive tape 141 is progressively bonded, that is, the direction in which the bonding roller 155 is rolled, is preferably the Y-axis direction which is orthogonal to the processing feed direction (X-axis direction) in which the modified portions 21 are formed in the separating layer forming step 1. In this manner, the separation debris on the fresh end surface 24 can effectively be removed in the tape separating step 4.

The description has been made above regarding the case in which the separation debris on the fresh end surface 24 of the ingot 10 is removed. Removal of separation debris on the separated surface 31 of the wafer 30 can also be performed in similar procedures.

### <Grinding Step 5>

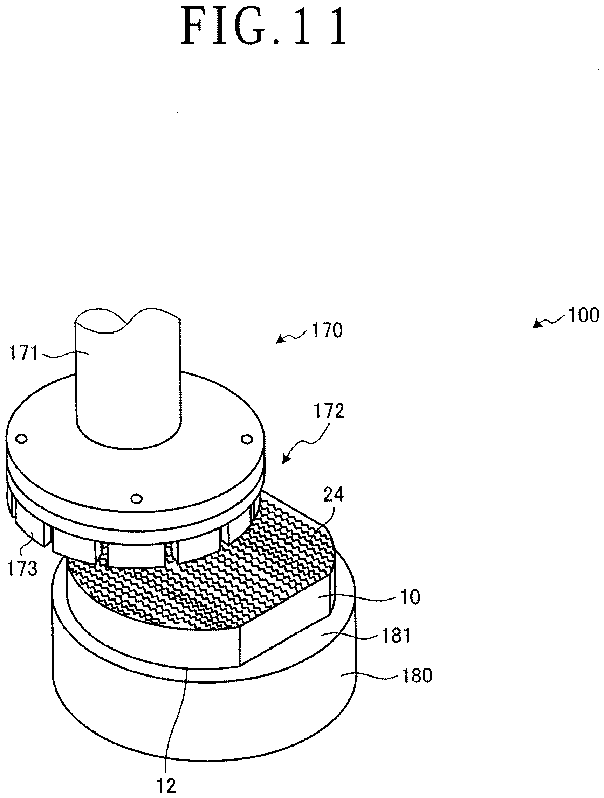

FIG. 11 is a schematic perspective view of the grinding unit 170, and depicts a state in the grinding step 5 illustrated in FIG. 3. The grinding step 5 is performed after the tape separating step 4 is performed. In the grinding step 5, the fresh end surface 24 of the ingot 10 or the separated surface 31 of the wafer 30 from which the separation debris has been removed is ground (in the example depicted in FIG. 11, the fresh end surface 24 of the ingot 10 is ground).

The grinding step 5 in the wafer production method of the present embodiment is performed by the grinding unit 170 of the wafer production machine 100. The grinding unit 170 includes grinding means for grinding and planarizing the fresh end surface 24 of the ingot 10 or the separated surface 31 of the wafer 30 held on the holding table 180. The grinding means includes a spindle 171 as a rotating shaft member, a grinding wheel 172 secured to a lower end of the spindle 171, grinding stones 173 mounted on a lower surface of the grinding wheel 172, and a grinding water supply nozzle (not depicted) that supplies grinding water.

The holding table 180 holds the ingot 10 or the wafer 30 on a holding surface 181 thereof. The holding surface 181 is formed from porous ceramics or the like and is in a disk shape. In the present embodiment, the holding surface 181 is a flat surface parallel to the horizontal direction. The holding surface 181 is connected, for example, to the vacuum suction source via a vacuum suction channel. The holding table 180 holds the second surface 12 of the ingot 10 or the first surface 11 of the wafer 30, i.e., a surface of the wafer 30 opposite to the separated surface 31, by suction on the holding surface 181.

It is to be noted that the holding table 160 may be used as the holding table 180. Described specifically, after the separation debris has been removed from the fresh end surface 24 of the ingot 10 or the separated surface 31 of the wafer 30 by the separation debris removing unit 140, the ingot 10 or the wafer 30 may be transferred, while being still held on the holding table 160, to a position where the fresh end surface 24 or the separated surface 31 faces the grinding unit 170.

A description will be made regarding the case in which the fresh end surface 24 of the ingot 10 is ground in the grinding step 5. As depicted in FIG. 11, in the grinding step 5, the second surface 12 of the ingot 10 is first held by suction on the holding surface 181 of the holding table 180. With the holding table 180 kept rotating about an axial center thereof, the grinding wheel 172 is rotated about an axial center thereof. It is to be noted that the grinding wheel 172 rotates about an axis of rotation which is parallel to the axial center of the holding table 180.

The grinding water is next supplied from the grinding water supply nozzle, and at the same time, the grinding stones 173 mounted on the lower surface of the grinding wheel 172 are brought closer to the holding table 180 at a predetermined feed rate, whereby the ingot 10 is ground by the grinding stones 173 from the side of the fresh end surface 24. As a consequence, irregularities on the fresh end surface 24 of the ingot 10 are removed.

The description has been made above regarding the case in which the fresh end surface 24 of the ingot 10 is ground. Grinding of the separated surface 31 of the wafer 30 can also be performed in similar procedures.

Upon completion of the grinding step 5, all the steps in the flow chart illustrated in FIG. 3 are ended. After that, the steps in the flow chart illustrated in FIG. 3 are repeatedly performed until a predetermined number of wafers 30 are produced from the ingot 10. It is to be noted that the surface referred to as the next first surface 11 in the steps in the flow chart illustrated in FIG. 3 is the fresh end surface 24 that has been ground in the grinding step 5.

As has been described above, in the wafer production method and the wafer production machine of the embodiments, the adhesive tape 141 is bonded to and separated from the fresh end surface 24 to remove separation debris therefrom, and the fresh end surface 24 is then ground. As a consequence, separation debris which firmly sticks on the fresh end surface 24 can also be removed. This makes it possible to suppress the inconvenience to be caused by sticking of separation debris on the grinding stones 173 in the grinding step 5, and hence contributes to an improvement in processing quality. Further, the wafer 30 and the ingot 10 are no longer transferred with separation debris existing thereon, and hence, there is a merit that cleanliness can be maintained inside the wafer production machine 100.

It is to be noted that the present invention is not limited to the embodiments described above. In other words, the present invention can be practiced with various changes and modifications to such an extent as not departing from the spirit of the present invention.

For example, the wafer production method may include a step of applying an external force to the separating layer 23, such as applying ultrasonic waves to the separating layer 23 or driving a wedge into the separating layer 23, after the separating layer forming step 1 but before the wafer separating step 2.

The present invention is not limited to the details of the above described preferred embodiments. The scope of the invention is defined by the appended claims and all changes and modifications as fall within the equivalence of the scope of the claims are therefore to be embraced by the invention.

## Claims

1. A wafer production method of producing a wafer from an ingot having a first surface and a second surface on a side opposite to the first surface, the method comprising:
a separating layer forming step of forming, in the ingot, a separating layer that includes modified portions and cracks propagating from the modified portions, by relatively moving the ingot and a focal point of a laser beam of a wavelength having transmissivity for the ingot, with the focal point positioned at a depth corresponding to a thickness of the wafer to be produced from a side of the first surface;
a wafer separating step of separating the wafer from the ingot by using the separating layer as a separation starting interface;
a tape bonding step of, after the wafer separating step is performed, bonding an adhesive tape to at least one of a separated surface of the wafer and a resulting fresh end surface of the ingot;
a tape separating step of removing separation debris stuck on the at least one surface, by separating the adhesive tape that has been bonded to the at least one surface in the tape bonding step from the at least one surface; and
a grinding step of, after the tape separating step is performed, grinding the at least one surface from which the separation debris has been removed.

2. A wafer production machine for producing a wafer from an ingot, the wafer production machine comprising:
a laser beam irradiation unit configured to form a separating layer in the ingot by applying a laser beam of a wavelength having transmissivity for the ingot to the ingot with a focal point of the laser beam positioned at a depth corresponding to a thickness of the wafer to be produced from an upper surface of the ingot;
a separating unit configured to separate the wafer from the ingot by using, as a separation starting interface, the separating layer formed by the laser beam irradiation unit;
a separation debris removing unit configured to remove separation debris that are present on at least one of a separated surface of the wafer that has been separated from the ingot by the separating unit and a resulting fresh end surface of the ingot, from the at least one surface, by bonding an adhesive tape to the at least one surface and separating the adhesive tape from the at least one surface with the separation debris stuck on the adhesive tape; and
a grinding unit including grinding stones that grind and planarize the at least one surface.
